Europäisches Patentamt

(19) European Patent Office

Office européen des brevets

(11) Publication number: **0 078 137**
**A2**

## (12) EUROPEAN PATENT APPLICATION

(21) Application number: **82305510.8**

(22) Date of filing: **18.10.82**

(51) Int. Cl.³: **H 01 L 21/24**

(30) Priority: **22.10.81 GB 8131838**

(43) Date of publication of application:
**04.05.83 Bulletin 83/18**

(84) Designated Contracting States:
**DE GB IT**

(71) Applicant: WESTINGHOUSE BRAKE AND SIGNAL
COMPANY LIMITED
Foundry Lane
Chippenham Wiltshire SN15 1RT(GB)

(72) Inventor: Garrett, John Mansell
Foundry Lane
Chippenham Wiltshire(GB)

(72) Inventor: Wood, Michael John
Foundry Lane
Chippenham Wiltshire(GB)

(74) Representative: Page, Edmund John et al,
PAGE & CO Temple Gate House Temple Gate
Bristol BS1 6PL(GB)

(54) Thermal migration process.

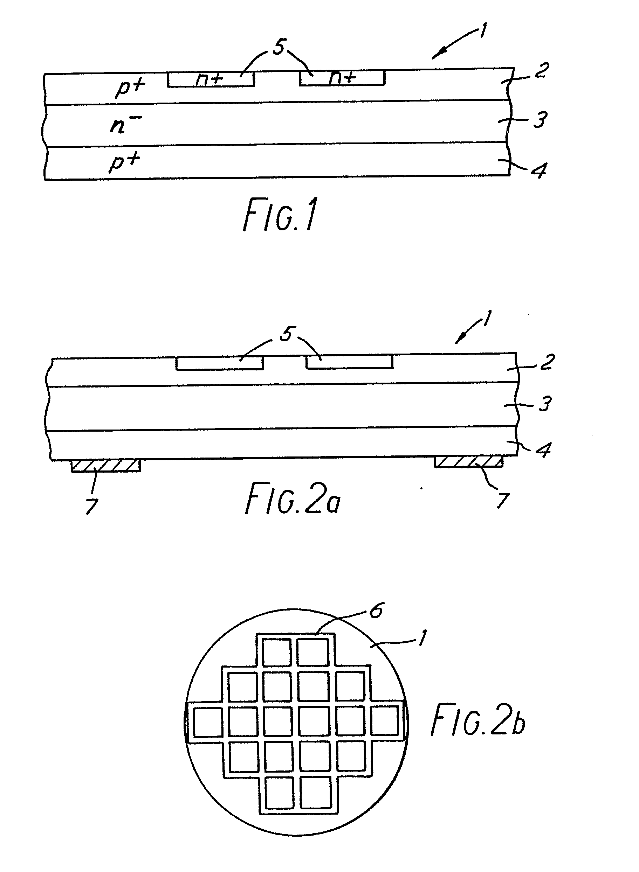

(57) A thermal migration process to produce a doped region (6) in a silicon semiconductor body (1) in which a face (8) of the silicon slice (1) having a layer of aluminium (7) is maintained at a temperature just below the eutectic temperature. A laser beam (11) is directed onto the opposite face (10) of the slice (1), locally heating, setting up a thermal gradient through the slice and further heating a small area of the first face above the eutectic temperature. The silicon and aluminium in that area form a region of molten alloy (7a) which migrates through the slice (1) leaving behind it a doped region (6). Because heating by the laser beam (11) is localised there is no need to deposit the aluminium in the plan of the final doped region (6) so that a uniform layer can be deposited over the whole slice (8). A finished doped region having, for example, a rectangular grid plan (6, Figure 2b) is produced by relative movement of the slice (1) and the laser beam (11) and this movement can be either a continuous, smooth and gradual movement to provide for substantially simultaneous movement of the doped region or, it may be a stepped movement providing a stepwise formation.

FIG.3

Croydon Printing Company Ltd

## Thermal Migration Process

The invention relates to a thermal migration process, also known as a temprature gradient zone melting process, and particularly to producing a doped semiconductor region by means of such a process.

The solubility of silicon in certain molten materials increases with increasing temperature, for example aluminium-silicon alloy has a single eutectic temperature occurring at 577$^{\circ}$C. Above that temperature in the liquid phase the solubility of silicon in molten aluminium increases with temperature whereas below the eutectic temperature the alloy exists in a combination of two solid phases.

A process for forming a PN junction employing temperature gradient zone melting of aluminium in silicon is described in U.S. Patent No. 3 899 362. In the process a thin strip-like film of aluminium is held in contact with one face of the silicon slice which is maintained at a temperature just below the eutectic temperature while the opposite exposed face of the slice is heated by radiation from infra-red lamps so as to generate a thermal gradient through the slice. The silicon-aluminium interface fuses at the eutectic temperature to form a molten zone in which the solubility of silicon is greater on the hotter side than on the cooler side causing the zone to migrate along the thermal gradient since silicon will be dissolved on the hotter side and precipitated on the cooler side leaving in its path a region of a solid solution of aluminium in silicon. Using infra-red lamps to heat the exposed face by radiation produces a typical temperature differential of $5^{\circ}$C across a 0.04 cm thick slice giving rise to a temperature gradient of $125^{\circ}$C/cm.

Disadvantages arise from the use of thermal gradients of such an order because they are easily affected by transverse variations of temperature. A major source of such irregularities is the variability of the intensity distribution of the incident radiation on the face of the slice.

The present invention seeks to overcome these draw-backs by heating a more localised area of the exposed face to a higher temperature.

According to the present invention there is provided a thermal migration process for producing in a body of silicon a doped region wherein a layer of aluminium is arranged in contact with a first surface of the silicon body, the first surface and the aluminium layer is heated to a temperature marginally below the eutectic temperature of aluminium-silicon alloy and, a second surface of the silicon body is heated to a higher temperature characterised in that, said second surface is heated by means of energy input from an incident laser beam.

The intensity of the incident laser beam is less than that which would cause fusion of the silicon.

In the case where it is desired to produce a network of doped regions in a silicon slice the layer of aluminium comprises a film deposited onto a face of the silicon slice, preferably formed according to the plan configuration of the doped region, and which is mainained at just below the eutectic temperature. A laser beam is then directed on to the opposite face of the silicon slice so as to establish a thermal gradient through the slice along which the aluminium subsequently migrates. The plan of the doped region may be traced out by relative movement of the laser beam and the silicon slice either by continuous scanning movement so that migration takes place in all parts substantially simultaneously or, by graduated stepwise movement so that migration takes place in stages.

The aluminium film may comprise a uniform deposit over a whole surface as thermomigration will take place selectively only in regions in which a thermal gradient is established. Alternatively, the film may be in the form of a pattern corresponding to the final doped region.

The invention will now be described by way of example with reference to the accompanying drawings, in which:

Fig. 1 is a detailed section through a diffused slice to be made into a multiple thyristor structure,

Fig. 2a shows a detailed section and,

Fig. 2b a plan view of the same slice including a grid of aluminium prior to thermomigrations,

0078137

Fig. 3 shows the slice of Fig. 2a in mid-thermomigration,

Fig. 4 shows the same slice upon completion,

Fig. 5 shows the location of passivating moats in the slice,

Fig. 6 shows a single thyristor following dicing of the slice, and

Fig. 7 shows a phase diagram of a silicon-aluminium system.

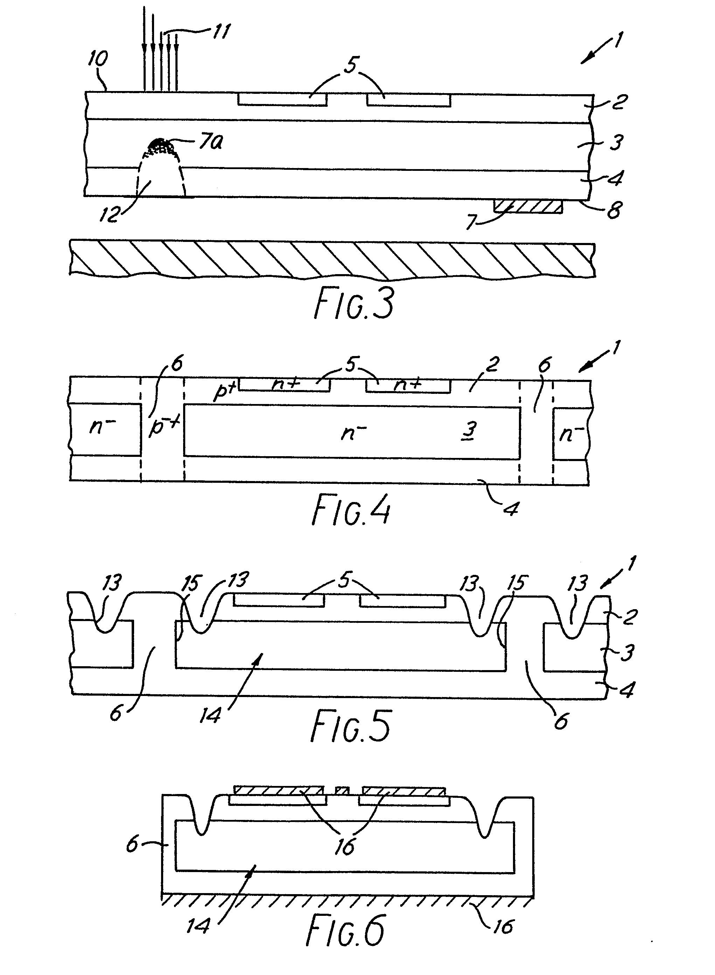

In the process for producing small low power thyristors a multiplicity of devices are formed on a single silicon slice. In a first stage of the process, see Fig. 1, a basic silicon slice of n-type conductivity under-goes a first diffusion process to produce three superimposed layers 2, 3, 4 of alternating conductivity and then by masking and second diffusion further $n^+$ type conductivity regions 5 are formed in one surface, eventually to become the thyristor emitter region. At this stage the three superimposed major layers 2, 3, 4 of alternating conductivity are continuous across the whole plane of the slice. In order to define the individual thyristor structures a semiconductor region 6 of p-type conductivity and plan configuration corresponding to Fig. 2b is formed in the slice, this p-type region 6 extends between the two major faces of the slice joining the outer p-type conductivity layers, as shown in Fig. 4.

In the first stage of this part of the process a photo-lithographic mask is formed on one face of the slice followed by an aluminium vapour desposition stage to deposit an aluminium grid structure 7 as shown in Fig. 2a in section, and in Fig. 2b in plan. In other applications of the invention a different doped region structure may be produced by the method described here.

In order to produce the p-type conductivity walls 6, shown in section in Fig. 4, the aluminium grid 7 is subjected to a thermal migration process, as follows:

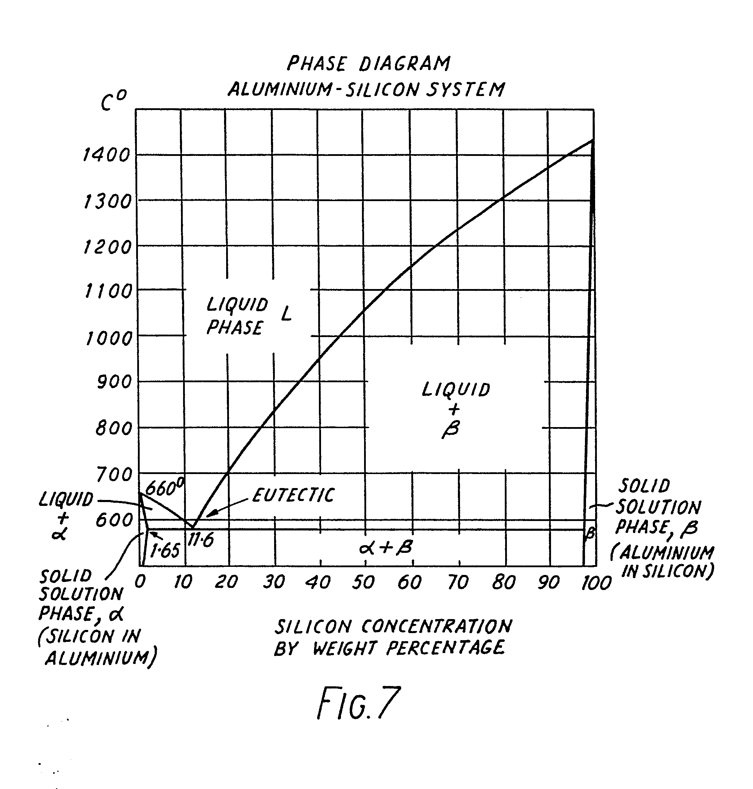

The diffused silicon slice 1 is placed aluminised face 8 downwards on a hot plate 9 whose temperature is maintained just below the eutectic temperature of aluminium-silicon alloy. The opposite face 10 is then irradiated by a laser beam 11 to establish a temperature gradient through the slice 1. Once the thermal gradient is established and the temperature of the aluminised face 8 is raised locally above the eutectic temperature the aluminium 7a commences to migrate in the direction of increasing temperature leaving behind it a region 12 of aluminium doped silicon having the required p-type conductivity. When the aluminium 7a appears on the top face 10 of the slice 1 the migration process is completed, the slice appearing in section as shown in Fig. 4. The slice is now ready for passivation as shown in Fig. 5 in which a moat 13 is inscribed around the edge of each thyristor device 14 just inside the inner periphery 15 of each walled unit of the grid structure 6. The electrode or terminal metallisation layers 16 are then deposited on the slice before it is diced along the centre of the lines of the grid structure 6 to form a multiplicity of individual passivated thyristor device 14 suitable for encapsulation mounting.

A phase diagram for an aluminium-silicon system is shown in Fig. 7 in which the percentage of silicon in the system is shown on the horizontal axis and temperature on the vertical axis. The left of the diagram therefore represents pure aluminium and the right of the diagram pure silicon. The lines in the diagram show demarcations between the principal phases of an aluminium-silicon system and it will be seen that at a concentration of 11.6% by weight of silicon the alloy exhibits a eutectic point at a temperature of 577°C. As described above in a thermal migration process one face of the slice is maintained just below the eutectic temperature, while the opposite face is irradiated by a laser beam to establish a thermal gradient. Within the area of impingement of a laser beam a typical surface temperature is 1,350°C which in a silicon slice 0.04 cm in thickness will establish a thermal gradient of 20,000°C/cm. Thus assuming, to a first order of approximation, a linear thermal gradient the total migration time of aluminium will be approximately 5 seconds. A suitable laser is a neodymium doped yttrium aluminium garnet laser operating at 1.06μ wavelength having a beam intensity, less than that which would cause fusion of the silicon.

To produce the required pattern such as the rectangular grid structure illustrated in Fig. 2b the aluminium film deposition process preferably comprises an aluminium vapour deposition stage followed by a photolithographic etching stage, both stages being well known in the art. The laser beam 11 (Fig. 3) is then scanned parallel to the deposited aluminium grid plan 6 (Fig. 2b) tracing out the grid pattern. The scanning is a relative movement of the slice 1 relative to the beam 11 and can be achieved by one of two alternative arrangements.

In the first arrangement the laser is mounted in a fixed position with its beam 11 produced along to z-axis, according to conventional orthogonal x,y,z axes nomenclature. The silicon slice 1 is mounted on a table  movable in the x and y axes planes and intersecting the beam 11. The mechanics of x and y plane movable tables is well known and therefore will be described only briefly.

The mounting table has two drives operating at right angles but in combination to achieve any combination of x-y co-ordinates or motion between pairs of co-ordinates. Where it is desired to employ a continuous scanning movement these drives are of a continuous running type and preferably of independently variable speed in order to be able to provide constant beam speed. Alternatively, where stepwise beam movement is to be provided the motor drives are of the stepping type.

In the second arrangement the silicon slice 1 is mounted in a fixed position and the laser scanned, by means of corresponding arrangements, in the x and y planes so that the beam traces out the grid pattern.

The scanning movement may be smooth and gradual progression or alternatively a stepwise movement so that the aluminium is caused to migrate through the slice in stages. In a stepwise process each migration region formed when the beam pauses may overlap with the previous region or else is formed so closely that the interstices are bridged by a subsequent diffusion operation.

The aluminium layer may be selectively deposited on the slice to provide only the plan of a grid structure or it may be deposited overall and selectively removed from the interstices of the grid. However, an overall uniform layer of aluminium may be left during the actual thermal migration stage of the process because the laser beam produces only localised heating of the slice. As the pattern of the desired doped region is traced out only the aluminium immediately underlying the beam impingement point is taken up leaving the remainder unaffected. Therefore it is not necessary to form a doped region pattern in the aluminium before thermomigration.

All thermal gradients in the slice plane are perpendicular to the beam and cause radial migration towards the centre line of the beam thus tending to set-up a focusing action. In contrast in conventional thermomigration all points on a slice surface are irradiated simultaneously resulting in various thermal gradients perpendicular to the direction of migration causing uneven simultaneous migration through the slice and skewing of the direction of migration in some regions.

Claims:

1. A thermal migration process for producing in a body (1) of silicon a doped region (6) wherein a layer (7) of aluminium is arranged in contact with a first surface (8) of the silicon body (1), the first surface (8) and the aluminium layer (7) is heated to a temperature marginally below the eutectic temperature of aluminium-silicon alloy and, a second surface (10) of the silicon body is heated to a higher temperature characterised in that, said second surface (10) is heated by means of energy input from an incident laser beam (11).

2. A thermal migration process as claimed in Claim 1 further characterised in that the layer (7) of aluminium is uniformly deposited on the first surface of the silicon body.

3. A thermal migration process as claimed in Claim 1 or Claim 2 further characterised in that the laser beam (11) and silicon body (1) are moved relatively to trace out the plan of a doped region structure (6) (Fig. 2).

4. A thermal migration process as claimed in Claim 3 further characterised in that the laser beam (11) is stationary and the silicon body (1) is moved relative thereto.

5. A thermal migration process as claimed in Claim 3 further characterised in that the silicon body (1) is stationary and the laser beam (11) is moved relative thereto.

6. A thermal migration process as claimed in any one of Claims 3 to 5 further characterised in that the relative movement is a continuous scanning movement.

7. A thermal migration process as claimed in any one of Claims 3 to 5 further characterised in that the relative movement is a stepwise movement.

8. A thermal migration process as claimed in any preceding claim further characterised in that the laser is a neodymium doped yttrium aluminium garnet type laser.

1/3

FIG.1

FIG.2a

FIG.2b

FIG.3

FIG.4

FIG.5

FIG.6

PHASE DIAGRAM
ALUMINIUM-SILICON SYSTEM

SILICON CONCENTRATION
BY WEIGHT PERCENTAGE

FIG. 7